(19) Europäisches Patentamt
European Patent Office
Office européen des brevets

(11) **EP 4 679 711 A1**

(12) **EUROPEAN PATENT APPLICATION**
published in accordance with Art. 153(4) EPC

(43) Date of publication:
**14.01.2026 Bulletin 2026/03**

(21) Application number: **23930098.1**

(22) Date of filing: **15.12.2023**

(51) International Patent Classification (IPC):
**H03F 1/02** (2006.01)

(52) Cooperative Patent Classification (CPC):
**H03F 1/02; H03F 1/34; H03F 3/68**

(86) International application number:
**PCT/CN2023/139097**

(87) International publication number:
**WO 2024/198533 (03.10.2024 Gazette 2024/40)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **24.03.2023 CN 202310357521**

(71) Applicant: **Huawei Technologies Co., Ltd.
Shenzhen, Guangdong 518129 (CN)**

(72) Inventor: **MU, Junchao
Shenzhen, Guangdong 518129 (CN)**

(74) Representative: **Pfenning, Meinig & Partner mbB
Patent- und Rechtsanwälte
Theresienhöhe 11a
80339 München (DE)**

(54) **OPERATIONAL AMPLIFIER, CHIP, AND ELECTRONIC DEVICE**

(57)  This application provides an operational amplifier, a chip, and an electronic device, and relates to the field of integrated circuit technologies. The operational amplifier includes a first power voltage end, a second power voltage end, a first-stage operational amplification circuit, and a second-stage operational amplification circuit. The first power voltage end is configured to receive a first power voltage signal, the second power voltage end is configured to receive a second power voltage signal, and a voltage value of the first power voltage signal is greater than a voltage value of the second power voltage signal. The first-stage operational amplification circuit is configured to: receive an input signal via a signal input end, and amplify the input signal under enabling control of the first power voltage signal, to generate a first drive signal. The second-stage operational amplification circuit is configured to: generate an output signal based on the first drive signal under enabling control of the second power voltage signal, and output the output signal via a signal output end. The operational amplifier has performance like low noise, low power consumption, high rate, and small area, and can be used in a chip.

FIG. 2

**Description**

This application claims priority to Chinese Patent Application No. 202310357521.1, filed with the China National Intellectual Property Administration on March 24, 2023 and entitled "OPERATIONAL AMPLIFIER, CHIP, AND ELECTRONIC DEVICE", which is incorporated herein by reference in its entirety.

**TECHNICAL FIELD**

This application relates to the field of integrated circuit technologies, and in particular, to an operational amplifier, a chip, and an electronic device.

**BACKGROUND**

There are a plurality of types of input stage circuits, for example, an N-type metal-oxide-semiconductor field-effect transistor (N type Metal Oxide Semiconductor Field Effect Transistor, NMOS FET) input stage circuit, a P-type metal-oxide-semiconductor field-effect transistor (P type Metal Oxide Semiconductor Field Effect Transistor, PMOS FET) input stage circuit, and a class AB input stage circuit.

Compared with the NMOS FET or PMOS FET input stage circuit, under same power consumption, both thermal noise and flicker noise (Flicker Noise) of the class AB input stage circuit can be reduced by about 6 dB. Alternatively, under same noise, both power consumption and an occupied area of the class AB input stage circuit may be reduced by about 75%. In other words, the class AB input stage circuit has features such as low noise, low power consumption, high rate, and small area.

An operational amplifier (Operational Amplifier, OP) is a circuit unit with a very high amplification factor. In an actual circuit, a functional module is usually formed by the operational amplifier together with a feedback circuit, and a requirement for performance of the operational amplifier is high. Because the class AB input stage circuit has the features such as low noise, low power consumption, high rate, and small area, how to apply the class AB input stage circuit to the operational amplifier to improve the performance of the operational amplifier becomes an urgent problem to be resolved in the field.

**SUMMARY**

Embodiments of this application provide an operational amplifier, a chip, and an electronic device, so that the operational amplifier has performance like low noise, low power consumption, high rate, and small area.

To achieve the foregoing objective, the following technical solutions are used in embodiments of this application.

According to a first aspect, an operational amplifier is provided. The operational amplifier includes a first power voltage end, a second power voltage end, a first-stage operational amplification circuit, and a second-stage operational amplification circuit. The first power voltage end is configured to receive a first power voltage signal, the second power voltage end is configured to receive a second power voltage signal, and a voltage value of the first power voltage signal is greater than a voltage value of the second power voltage signal. The first-stage operational amplification circuit is coupled to the first power voltage end. The first-stage operational amplification circuit is configured to: receive an input signal via a signal input end, and amplify the input signal under enabling control of the first power voltage signal, to generate a first drive signal. The second-stage operational amplification circuit is coupled to the first-stage operational amplification circuit and the second power voltage end. The second-stage operational amplification circuit is configured to: generate an output signal based on the first drive signal under enabling control of the second power voltage signal, and output the output signal via a signal output end.

In the foregoing embodiment of this application, the operational amplifier includes the first-stage operational amplification circuit and the second-stage operational amplification circuit. The first-stage operational amplification circuit uses a class AB input stage circuit architecture. Because the class AB input stage circuit has features such as low noise, low power consumption, high rate, and small area, the operational amplifier has performance like low noise, low power consumption, high rate, and small area.

In addition, the first-stage operational amplification circuit is coupled to the first power voltage end, and the first power voltage end is configured to transmit the first power voltage signal to the first-stage operational amplification circuit, to supply power to the first-stage operational amplification circuit. The second-stage operational amplification circuit is coupled to the second power voltage end, and the second power voltage end is configured to provide the second power voltage signal for the second-stage operational amplification circuit, to supply power to the second-stage operational amplification circuit.

The voltage value of the first power voltage signal is set to be greater than the voltage value of the second power voltage signal, so that a power voltage of the first-stage operational amplification circuit is greater than a power voltage of the second-stage operational amplification circuit. A maximum voltage of the output signal of the second-stage operational amplification circuit may be close to the power voltage (the second power voltage signal) of the second-stage operational amplification circuit. When the second-stage operational amplification circuit is coupled to the first-stage operational amplification circuit via a feedback circuit, a maximum voltage of the input signal of the first-stage operational amplification circuit may be close to the second power voltage signal. Therefore, the power voltage (the first power voltage signal) of the first-stage operational amplification circuit is constantly greater than the voltage of the input signal of the first-stage operational amplification circuit, so that the first-stage operational amplification circuit can be prevented from being locked.

In some embodiments, the first-stage operational amplification circuit includes a first differential input pair and a first current source. The first differential input pair includes a first transistor and a second transistor, and the first current source includes a third transistor. A gate of the first transistor and a gate of the second transistor are separately coupled to the signal input end, and a source of the first transistor and a source of the second transistor are separately coupled to a drain of the third transistor. A source of the third transistor is coupled to the first power voltage end.

In some embodiments, $|V_{dd1}|>|V_{dd2}|+|V_{GS1}|+||V_{DSat3}|$, where $V_{dd1}$ is the voltage value of the first power voltage signal, $V_{dd2}$ is the voltage value of the second power voltage signal, $V_{GS1}$ is a gate-source voltage difference of the first transistor during operating in a saturated region, and $V_{DSat3}$ is a source-drain voltage difference of the third transistor in a critical state between a linear region and a saturated region.

It may be understood that a first input end of the first-stage operational amplification circuit is coupled to the gate of the first transistor, and a voltage difference between the first power voltage end and the first input end is equal to a sum of an actual gate-source voltage difference of the first transistor and an actual source-drain voltage difference of the third transistor.

A maximum voltage of an input signal of the first input end may be close to $V_{dd2}$. $|V_{dd1}|>|V_{dd2}|+|V_{GS1}|+|V_{DSat3}|$ is set, so that $|V_{dd1}|>|-|V_{dd2}|>|V_{GS1}|+|V_{DSat3}|$, that is, the voltage difference between the first power voltage end and the first input end is greater than the gate-source voltage difference of the first transistor during operating in the saturated region and the source-drain voltage difference of the third transistor in the critical state between the linear region and the saturated region, so that the actual gate-source voltage difference of the first transistor is greater than the gate-source voltage difference of the first transistor during operating in the saturated region, and the actual source-drain voltage difference of the third transistor is greater than the source-drain voltage difference of the third transistor in the critical state between the linear region and the saturated region, to ensure that the first transistor and the third transistor operate in the saturated regions. This can ensure normal operating of the first-stage operational amplification circuit, and prevent the first-stage operational amplification circuit from being locked.

A second input end of the first-stage operational amplification circuit is coupled to the gate of the second transistor, and a voltage difference between the first power voltage end and the second input end is equal to a sum of an actual gate-source voltage difference of the second transistor and an actual source-drain voltage difference of the third transistor.

A maximum input voltage of the second input end may be close to $V_{dd2}$. $|V_{dd1}|>|+|V_{GS2}|+|V_{DSat3}|$ is set, so that $|V_{dd1}|>|-|V_{dd2}|>|V_{GS2}|+|V_{DSat3}|$, that is, the voltage difference between the first power voltage end and the second input end is greater than a gate-source voltage difference of the second transistor during operating in a saturated region and the source-drain voltage difference of the third transistor in the critical state of the linear region and the saturated region, so that the actual gate-source voltage difference of the second transistor is greater than the gate-source voltage difference of the second transistor during operating in the saturated region, and the actual source-drain voltage difference of the third transistor is greater than the source-drain voltage difference of the third transistor in the critical state between the linear region and the saturated region, to ensure that the second transistor and the third transistor operate in the saturated regions. This can ensure normal operating of the first-stage operational amplification circuit, and prevent the first-stage operational amplification circuit from being locked.

In some embodiments, the first transistor, the second transistor, and the third transistor are all P-type transistors.

In some embodiments, the first-stage operational amplification circuit further includes a second differential input pair and a second current source. The second differential input pair includes a fourth transistor and a fifth transistor. A gate of the fourth transistor and a gate of the fifth transistor are separately coupled to the signal input end, and a source of the fourth transistor and a source of the fifth transistor are separately coupled to the second current source. A drain of the fourth transistor is coupled to a drain of the first transistor, and a drain of the fifth transistor is coupled to a drain of the second transistor.

In the foregoing embodiment, the first-stage operational amplification circuit includes the first differential input pair and the second differential input pair, and the second differential input pair may be used as a current mirror load of the first differential input pair.

In addition, both the gate of the first transistor and the gate of the fourth transistor are coupled to the signal input end, and both the gate of the second transistor and the gate of the fifth transistor are coupled to the signal input end, so that both the first differential input pair and the second differential input pair are coupled to the signal input end, thereby implementing current source reuse. This helps reduce a current value and noise in the first-stage operational amplification circuit, thereby helping reduce power consumption of the first-stage operational amplification circuit. In addition, this helps reduce an area of the first-stage operational amplification circuit, and improve a rate of the first-stage operational amplification circuit.

In some embodiments, both the fourth transistor and the fifth transistor are N-type transistors.

In some embodiments, the operational amplifier further includes a common-mode feedback circuit. The common-mode feedback circuit is coupled to the signal output end of the second-stage operational amplification circuit and the first current source. The common-mode feedback circuit is configured to: generate and output an error feedback signal to the first current source based on the output signal from the signal output end, to feed back the error feedback signal to the first-stage operational amplification circuit.

In some embodiments, the common-mode feedback circuit includes a common-mode detection circuit and a differential input single-ended output amplifier. An input end of the common-mode detection circuit is coupled to the signal output end, an output end of the common-mode detection circuit is coupled to a negative-phase input end of the differential input single-ended output amplifier, and the common-mode detection circuit is configured to generate a common-mode voltage signal based on the output signal.

A positive-phase input end of the differential input single-ended output amplifier is configured to receive a reference voltage signal, an output end of the differential input single-ended output amplifier is coupled to the first current source, and the differential input single-ended output amplifier is configured to generate and output the error feedback signal based on the common-mode voltage signal and the reference voltage signal.

In some embodiments, the operational amplifier further includes a third voltage end, and the third voltage end is configured to receive a second drive signal. The second-stage operational amplification circuit is coupled to the first-stage operational amplification circuit, the second power voltage end, and the third voltage end. The second-stage operational amplification circuit is configured to generate the output signal based on the first drive signal and the second drive signal under the enabling control of the second power voltage signal.

In some embodiments, the second-stage operational amplification circuit includes a first output sub-circuit and a second output sub-circuit. The first output sub-circuit includes a sixth transistor and a seventh transistor. A gate of the sixth transistor is coupled to the third voltage end, and a source of the sixth transistor is coupled to the second power voltage end. A gate of the seventh transistor is coupled to the first-stage operational amplification circuit, and a drain of the seventh transistor is coupled to a drain of the sixth transistor.

The second output sub-circuit includes an eighth transistor and a ninth transistor. A gate of the eighth transistor is coupled to the third voltage end, and a source of the eighth transistor is coupled to the second power voltage end. A gate of the ninth transistor is coupled to the first-stage operational amplification circuit, and a drain of the ninth transistor is coupled to a drain of the eighth transistor.

In the foregoing embodiment of this application, the operational amplifier includes the first transistor to the ninth transistor, and a quantity of transistors is small. This helps reduce a power voltage (the first power voltage signal and the second power voltage signal) of the operational amplifier, thereby helping reduce power consumption of the operational amplifier.

In some embodiments, both the sixth transistor and the eighth transistor are P-type transistors, and both the seventh transistor and the ninth transistor are N-type transistors.

In some embodiments, the operational amplifier further includes a compensation circuit. The compensation circuit is coupled between the first-stage operational amplification circuit and the second-stage operational amplification circuit, and the compensation circuit is configured to perform filtering processing on the output signal.

In some embodiments, the compensation circuit includes a first compensation sub-circuit and a second compensation sub-circuit. The first compensation sub-circuit includes a first capacitor and a first resistor that are disposed in series, and the first capacitor and the first resistor are coupled between the first-stage operational amplification circuit and the first output sub-circuit. The second compensation sub-circuit includes a second capacitor and a second resistor that are disposed in series, and the second capacitor and the second resistor are coupled between the first-stage operational amplification circuit and the second output sub-circuit.

According to a second aspect, a chip is provided. The chip includes the operational amplifier in any one of the foregoing embodiments, a third resistor, and a fourth resistor. In the first-stage operational amplification circuit of the operational amplifier, the signal input end includes the first input end and the second input end. In the second-stage operational amplification circuit, the signal output end includes a first output end and a second output end. The first input end corresponds to the first output end, and the second input end corresponds to the second output end.

The first input end is coupled to the first output end via the third resistor, and the second input end is coupled to the second output end via the fourth resistor, to feed back an output signal of the signal output end to the signal input end.

According to a third aspect, an electronic device is provided. The electronic device includes the chip in any one of the foregoing embodiments and a circuit board. The chip is coupled to the circuit board.

It may be understood that, for beneficial effects that can be achieved by the chip and the electronic device provided in the foregoing embodiments of this application, refer to the foregoing beneficial effects of the operational amplifier. Details are not described herein again.

**BRIEF DESCRIPTION OF DRAWINGS**

To describe technical solutions in this application more clearly, the following briefly describes accompanying drawings used in describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, an actual time sequence of a signal, and the like in embodiments of this application.

FIG. 1 is an exploded view of a structure of a mobile phone according to an embodiment of this application;
FIG. 2 is a block diagram of a structure of an operational amplifier according to an embodiment of this application;
FIG. 3 is a circuit diagram of an operational amplifier according to an embodiment of this application;
FIG. 4 is a circuit diagram of a trans-impedance amplifier according to an embodiment of this application; and
FIG. 5 is a circuit diagram of a filter according to an embodiment of this application.

**DESCRIPTION OF EMBODIMENTS**

The following clearly and completely describes technical solutions in some embodiments of this application with reference to accompanying drawings. It is clear that the described embodiments are merely a part rather than all of embodiments of this application. All other embodiments obtained by a person of ordinary skill in the art based on embodiments of this application shall fall within the protection scope of this application.

Unless otherwise required by the context, throughout the specification and claims, the term "include" is interpreted as "open and inclusive", that is, "include but not limited to". In the description of the specification, terms such as "an embodiment", "some embodiments", "example embodiments", "examples", or "some examples" are intended to indicate that specific features, structures, materials, or characteristics related to the embodiments or examples are included in at least one embodiment or example of the present disclosure. The schematic representations of the foregoing terms do not necessarily refer to a same embodiment or example. In addition, the specific features, structures, materials, or characteristics may be included in any one or more embodiments or examples in any appropriate manner.

The terms "first" and "second" mentioned below are merely intended for a purpose of description, and shall not be understood as an indication or implication of relative importance or an implicit indication of a quantity of indicated technical features. Therefore, a feature limited by "first" or "second" may explicitly indicate or implicitly include one or more such features. In the description of embodiments of this application, unless otherwise specified, "a plurality of" means two or more than two.

When some embodiments are described, "coupling" may be used. The term "coupling" indicates, for example, that two or more components are in direct physical contact or electrical contact, or may be indirectly connected via an intermediate medium. Embodiments disclosed herein are not necessarily limited to content of this specification.

The use of "configured to" in this specification implies an open and inclusive language, and does not exclude a device that is applicable to or configured to perform an additional task or step.

In addition, the use of "based on" implies openness and inclusiveness, since processes, steps, calculations, or other actions "based on" one or more of conditions or values may be based in practice on additional conditions or values outside the described values.

As used herein, "about" includes a stated value and an average value within an acceptable deviation range of a particular value, where the acceptable deviation range is determined by a person of ordinary skill in the art by taking into account an error (namely, a limitation of a measurement system) related to a measurement being discussed and a specific quantity of measurements.

An embodiment of this application provides an electronic device. The electronic device is, for example, a consumer electronic product, a home electronic product, a vehicle-mounted electronic product, a financial terminal product, or a communication electronic product. The consumer electronic product is, for example, a mobile phone, a tablet computer, a notebook computer, an e-reader, a personal computer (Personal Computer, PC), a central processing unit (Central Processing Unit, CPU), a personal digital assistant (Personal Digital Assistant, PDA), a desktop display, a smart wearable product (for example, a smartwatch or a smart band), a virtual reality (Virtual Reality, VR) terminal device, an augmented reality (Augmented Reality, AR) terminal device, or an uncrewed aerial vehicle. The home electronic product is, for example, an intelligent lock, a television, a remote control, a refrigerator, and a small rechargeable household appliance (such as a soy milk maker or a robot vacuum). The vehicle-mounted electronic product is, for example, a vehicle-mounted navigator or a vehicle-mounted high-density digital video disc. The financial terminal product is, for example, an automated teller machine or a terminal for self-help service handling. The communication electronic product is, for example, a communication device like a server, a memory, a base station, or an internet of things (Internet of Things, IOT) product.

A specific form of the electronic device is not specifically limited in embodiments of this application. For ease of description, an example in which the electronic device is a mobile phone is used for description in the following embodiments.

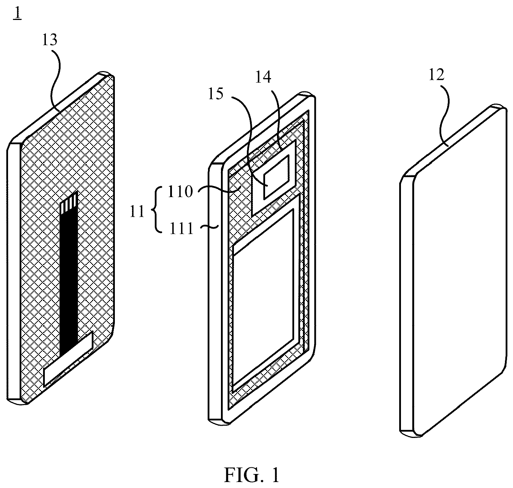

FIG. 1 is an exploded view of a structure of a mobile phone according to an embodiment of this application.

Refer to FIG. 1. A mobile phone 1 includes a middle frame 11, a rear housing 12, and a display 13. The rear housing 12 and the display 13 are respectively located on two opposite sides of the middle frame 11, and the middle frame 11 includes a bearing plate 110 configured to bear the display 13, and a frame 111 surrounding the bearing plate 110.

The mobile phone 1 may further include a circuit board 14 and a chip 15 disposed on the circuit board 14. The chip 15 is coupled to the circuit board 14. The circuit board 14 is disposed on a side that is of the bearing plate 110 and that is close to the rear housing 12.

The chip 15 may be, for example, a die, or may be a packaged chip. The packaged chip may include one or more dies. The chip 15 may be a processor chip, a driver chip, a micro-electro-mechanical system (Micro-Electro-Mechanical System, MEMS) chip, a storage chip, a Wi-Fi radio frequency (Radio Frequency, RF) chip, a Bluetooth (Bluetooth, BT) chip, a terminal radio frequency chip, a radio frequency power amplifier chip, a power management chip, an audio processor chip, a touchscreen control chip, an image sensor chip, a charging protection chip, or the like. This is not limited in embodiments of this application.

An operational amplifier (Operational Amplifier, OP) is a circuit unit with a very high amplification factor, and may be widely used in various chips. In the chip 15, the operational amplifier forms a functional module together with a feedback circuit, and performance of the operational amplifier is closely related to performance of the functional module.

In a related technology, there are a plurality of types of input stage circuits, for example, an N-type metal-oxide-semiconductor field-effect transistor (N type Metal Oxide Semiconductor Field Effect Transistor, NMOS FET) input stage circuit, a P-type metal-oxide-semiconductor field-effect transistor (P type Metal Oxide Semiconductor Field Effect Transistor, PMOS FET) input stage circuit, and a class AB input stage circuit.

Compared with the NMOS FET or PMOS FET input stage circuit, under same power consumption, both thermal noise and flicker noise (Flicker Noise) of the class AB input stage circuit can be reduced by about 6 dB. Alternatively, under same noise, both power consumption and an occupied area of the class AB input stage circuit may be reduced by about 75%. In other words, the class AB input stage circuit has features such as low noise, low power consumption, high rate, and small area.

In view of this, how to apply the class AB input stage circuit to the operational amplifier to improve the performance of the operational amplifier becomes an urgent problem to be resolved in the field.

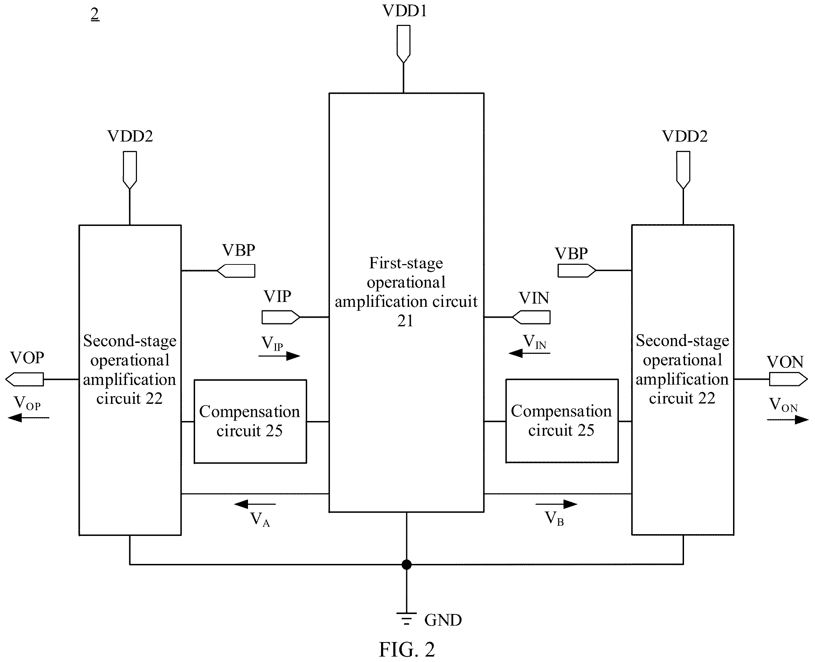

Some embodiments of this application provide an operational amplifier. FIG. 2 is a block diagram of a structure of an operational amplifier according to an embodiment of this application.

Refer to FIG. 2. An operational amplifier 2 includes a first power voltage end VDD1 and a second power voltage end VDD2. The first power voltage end VDD1 is configured to receive a first power voltage signal, and the second power voltage end VDD2 is configured to receive a second power voltage signal. A voltage value of the first power voltage signal is greater than a voltage value of the second power voltage signal.

Refer to FIG. 2. The operational amplifier 2 further includes a first-stage operational amplification circuit 21. The first-stage operational amplification circuit 21 is coupled to the first power voltage end VDD1, and the first power voltage end VDD1 is configured to transmit the first power voltage signal to the first-stage operational amplification circuit 21, to supply power to the first-stage operational amplification circuit 21. The first-stage operational amplification circuit 21 includes a signal input end (VIP and VIN). The first-stage operational amplification circuit 21 is configured to: receive an input signal via the signal input end, and amplify the input signal under enabling control of the first power voltage signal, to generate a first drive signal.

For example, the signal input end includes a first input end VIP and a second input end VIN, and the first input end VIP and the second input end VIN are respectively configured to receive input signals ($V_{IP}$ and $V_{IN}$). The first-stage operational amplification circuit 21 may amplify a signal $V_{IP}$ to generate a drive signal $V_A$, and amplify a signal $V_{IN}$ to generate a drive signal $V_B$.

The first-stage operational amplification circuit 21 is a class AB input stage circuit.

Refer to FIG. 2. The operational amplifier 2 further includes a second-stage operational amplification circuit 22. The second-stage operational amplification circuit 22 is coupled to the first-stage operational amplification circuit 21 and the second power voltage end VDD2, and the second power voltage end VDD2 is configured to provide the second power voltage signal for the second-stage operational amplification circuit 22, to supply power to the second-stage operational amplification circuit 22. The second-stage operational amplification circuit 22 includes a signal output end (VOP and VON). The second-stage operational amplification circuit 22 is configured to: generate an output signal based on the first drive signal from the first-stage operational amplification circuit 21 under enabling control of the second power voltage signal, and output the output signal via the signal output end.

For example, the signal output end includes a first output end VOP and a second output end VON, the first output end VOP corresponds to the first input end VIP, and the second output end VON corresponds to the second input end VIN. The second-stage operational amplification circuit 22 transfers an output signal $V_{OP}$ to the outside via the first output end VOP, and transfers an output signal $V_{ON}$ to the outside via the second output end VON.

In the foregoing embodiment of this application, the operational amplifier 2 includes the first-stage operational amplification circuit 21 and the second-stage operational amplification circuit 22. The first-stage operational amplification circuit 21 uses a class AB input stage circuit architecture. Because the class AB input stage circuit has features such as low noise, low power consumption, high rate, and small area, the operational amplifier 2 has performance like low noise, low power consumption, high rate, and small area.

According to the foregoing description, the operational amplifier is usually used in combination with a feedback circuit. To be specific, an output end of the operational amplifier is coupled to an input end via the feedback circuit. In this case, an increase in an output voltage of the output end causes an increase in an input voltage of the input end. In a related technology, the first-stage operational amplification circuit and the second-stage operational amplification circuit use a same power voltage, and an output voltage of the output end increases, and may be at most close to the power voltage, so that the input voltage of the input end is close to the power voltage. An input voltage of the first-stage operational amplification circuit is close to the power voltage of the first-stage operational amplification circuit, consequently, the first-stage operational amplification circuit stops operating (is locked), and the second-stage operational amplification circuit cannot be driven to generate the output signal.

However, in the foregoing embodiment of this application, the first-stage operational amplification circuit 21 is coupled to the first power voltage end VDD1, and the first power voltage end VDD1 is configured to transmit the first power voltage signal to the first-stage operational amplification circuit 21, to supply power to the first-stage operational amplification circuit 21. The second-stage operational amplification circuit 22 is coupled to the second power voltage end VDD2, and the second power voltage end VDD2 is configured to provide the second power voltage signal for the second-stage operational amplification circuit 22, to supply power to the second-stage operational amplification circuit 22.

The voltage value of the first power voltage signal is set to be greater than the voltage value of the second power voltage signal, so that the power voltage of the first-stage operational amplification circuit 21 is greater than the power voltage of the second-stage operational amplification circuit 22. A maximum voltage of the output signal of the second-stage operational amplification circuit 22 may be close to the power voltage (the second power voltage signal) of the second-stage operational amplification circuit 22. When the second-stage operational amplification circuit 22 is coupled to the first-stage operational amplification circuit 21 via the feedback circuit, a maximum voltage of the input signal of the first-stage operational amplification circuit 21 may be close to the second power voltage signal. Therefore, the power voltage (the first power voltage signal) of the first-stage operational amplification circuit 21 is constantly greater than the voltage of the input signal of the first-stage operational amplification circuit 21, so that the first-stage operational amplification circuit 21 can be prevented from being locked.

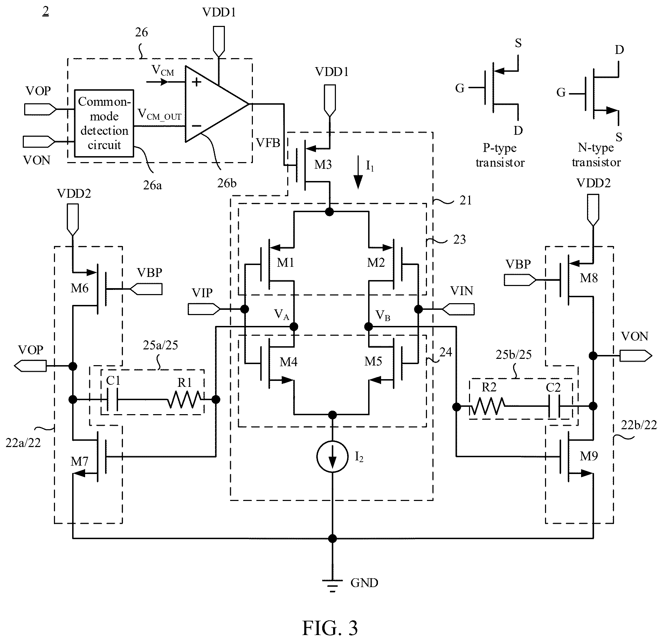

FIG. 3 is a circuit diagram of an operational amplifier according to an embodiment of this application.

Refer to FIG. 3. The first-stage operational amplification circuit 21 includes a first differential input pair 23 and a first current source $I_1$. The first differential input pair 23 includes a first transistor M1 and a second transistor M2, and the first current source $I_1$ includes a third transistor M3 and a feedback voltage input end VFB.

A gate of the first transistor M1 is coupled to the first input end VIP, a source of the first transistor M1 is coupled to a drain of the third transistor M3, a gate of the third transistor M3 is coupled to the feedback voltage input end VFB, and a source of the third transistor M3 is coupled to the first power voltage end VDD1, to form a conductive path between the first power voltage end VDD1 and the first input end VIP.

It may be understood that a voltage difference between the first power voltage end VDD1 and the first input end VIP is equal to a sum of an actual gate-source voltage difference of the first transistor M1 and an actual source-drain voltage difference of the third transistor M3.

$|V_{dd1}| > |V_{dd2}| + |V_{GS1}| + |V_{DSat3}|$, where $V_{dd1}$ is a voltage value of the first power voltage signal, $V_{dd2}$ is a voltage value of the second power voltage signal, $V_{GS1}$ is a gate-source voltage difference of the first transistor M1 during operating in a saturated region, and $V_{DSat3}$ is a source-drain voltage difference of the third transistor M3 in a critical state between a linear region and a saturated region.

According to the foregoing description, a maximum input voltage of the first input end VIP may be close to $V_{dd2}$. $|V_{dd1}| > |V_{dd2}| + |V_{GS1}| + |V_{DSat3}|$ is set, so that $|V_{dd1}| - |V_{dd2}| > |V_{GS1}| + |V_{DSat3}|$, that is, the voltage difference between the first power voltage end VDD1 and the first input end VIP is greater than the gate-source voltage difference of the first transistor M1 operating in the saturated region and the source-drain voltage difference of the third transistor M3 in the critical state between the linear region and the saturated region, so that the actual gate-source voltage difference of the first transistor M1 is greater than the gate-source voltage difference of the first transistor M1 operating in the saturated region, and the actual source-drain voltage difference of the third transistor M3 is greater than the source-drain voltage difference of the third transistor M3 in the critical state between the linear region and the saturated region, to ensure that the first transistor M1 and the third transistor M3 operate in the saturated regions. This can ensure normal operating of the first-stage operational amplification circuit 21, and prevent the first-stage operational amplification circuit 21 from being locked.

Refer to FIG. 3. A gate of the second transistor M2 is coupled to the second input end VIN, a source of the second transistor M2 is coupled to the drain of the third transistor M3, and the source of the third transistor M3 is coupled to the first power voltage end VDD1, to form a conductive path between the second input end VIN and the first power voltage end VDD1.

It may be understood that a voltage difference between the first power voltage end VDD1 and the second input end VIN is equal to a sum of an actual gate-source voltage difference of the second transistor M2 and the actual source-drain voltage difference of the third transistor M3.

$|V_{dd1}|>|V_{dd2}|+|V_{GS2}|+||V_{DSat3}|$, where $V_{dd1}$ is the voltage value of the first power voltage signal, $V_{dd2}$ is the voltage value of the second power voltage signal, $V_{GS2}$ is a gate-source voltage difference of the second transistor during operating in a saturated region, and $V_{DSat3}$ is a source-drain voltage difference of the third transistor during operating in a saturated region.

According to the foregoing description, a maximum input voltage of the second input end VIN may be close to $V_{dd2}$. $|V_{dd1}|>|V_{dd2}|+|V_{GS2}|+||V_{DSat3}|$ is set, so that $|V_{dd1}|-|V_{dd2}|>|V_{GS2}|+|V_{DSat3}|$, that is, the voltage difference between the first power voltage end VDD1 and the second input end VIN is greater than a gate-source voltage difference of the second transistor M2 during operating in the saturated region and a source-drain voltage difference of the third transistor M3 in the critical state between the linear region and the saturated region, so that the actual gate-source voltage difference of the second transistor M2 is greater than the gate-source voltage difference of the second transistor M2 during operating in the saturated region, and the actual source-drain voltage difference of the third transistor M3 is greater than the source-drain voltage difference of the third transistor M3 in the critical state between the linear region and the saturated region, to ensure that the second transistor M2 and the third transistor M3 operate in the saturated regions. This can ensure normal operating of the first-stage operational amplification circuit 21, and prevent the first-stage operational amplification circuit 21 from being locked.

For example, refer to FIG. 3. The first transistor M1, the second transistor M2, and the third transistor M3 are all P-type transistors. For example, the three transistors are all P-type metal-oxide-semiconductor field-effect transistors (P type Metal Oxide Semiconductor Field Effect Transistors, PMOS FETs).

In some embodiments, refer to FIG. 3. The operational amplifier 2 further includes a ground end GND.

The first-stage operational amplification circuit 21 further includes a second differential input pair 24 and a second current source $I_2$. The second differential input pair 24 includes a fourth transistor M4 and a fifth transistor M5. A gate of the fourth transistor M4 is coupled to the gate of the first transistor M1, that is, both the gate of the first transistor M1 and the gate of the fourth transistor M4 are coupled to the first input end VIP. A source of the fourth transistor M4 is coupled to the ground end GND through the second current source $I_2$, and a drain of the fourth transistor M4 is coupled to a drain of the first transistor M1.

A gate of the fifth transistor M5 is coupled to the gate of the second transistor M2, that is, both the gate of the second transistor M2 and the gate of the fifth transistor M5 are coupled to the second input end VIN. A source of the fifth transistor M5 is coupled to the ground end GND through the second current source $I_2$, and a drain of the fifth transistor M5 is coupled to a drain of the second transistor M2.

For example, refer to FIG. 3. Both the fourth transistor M4 and the fifth transistor M5 are N-type transistors. For example, both the two transistors are N-type metal-oxide-semiconductor field-effect transistors (N type Metal Oxide Semiconductor Field Effect Transistors, NMOS FETs).

In the foregoing embodiment, the first-stage operational amplification circuit 21 includes the first differential input pair 23 and the second differential input pair 24, and the second differential input pair 24 may be used as a current mirror load of the first differential input pair 23.

In addition, both the gate of the first transistor M1 and the gate of the fourth transistor M4 are coupled to the first input end VIP, and both the gate of the second transistor M2 and the gate of the fifth transistor M5 are coupled to the second input end VIN, so that both the first differential input pair 23 and the second differential input pair 24 are coupled to the first input end VIP, and are coupled to the second input end VIN, thereby implementing current source reuse. This helps reduce a current value and noise in the first-stage operational amplification circuit 21, thereby helping reduce power consumption of the first-stage operational amplification circuit 21. In addition, this helps reduce an area of the first-stage operational amplification circuit 21, and improve a rate of the first-stage operational amplification circuit 21.

For example, power consumption of an existing first-stage operational amplification circuit of an operational amplifier is $P = UI$. The first-stage operational amplification circuit 21 uses a class AB input stage circuit architecture. Usually, a power voltage of the first-stage operational amplification circuit 21 is increased to about 150%, and a current of the first-stage operational amplification circuit 21 is reduced to about 25%. Therefore, power consumption of the first-stage operational amplification circuit 21 is $P' = 1.5U \times 0.25I = 0.375UI$, $P' = 0.375P$, and the power consumption of the first-stage operational amplification circuit 21 is reduced by 62.5%.

In addition, because the current of the first-stage operational amplification circuit 21 is reduced to about 25%, the area of the first-stage operational amplification circuit 21 is reduced to 1/4 of the existing first-stage operational amplification circuit, so that a rate of the operational amplifier 2 is increased by four times.

In some embodiments, refer to FIG. 3. The operational amplifier 2 further includes a third voltage end VBP, and the third voltage end VBP is configured to receive a second drive signal.

The second-stage operational amplification circuit 22 is coupled to the first-stage operational amplification circuit 21, the second power voltage end VDD2, and the third voltage end VBP. The second-stage operational amplification circuit 22 is configured to generate the output signal ($V_{OP}$ and $V_{ON}$) based on the first drive signal ($V_A$ and $V_B$) from the first-stage operational amplification circuit 21 and the second drive signal from the third voltage end VBP under the enabling control of the second power voltage signal.

For example, refer to FIG. 3. The second-stage operational amplification circuit 22 includes a first output sub-circuit 22a and a second output sub-circuit 22b. The first output sub-circuit 22a includes a sixth transistor M6 and a seventh transistor M7. A gate of the sixth transistor M6 is coupled to the third voltage end VBP, a source of the sixth transistor M6 is coupled to the second power voltage end VDD2, and a drain of the sixth transistor M6 is coupled to a drain of the seventh transistor M7. The first output end VOP is coupled to the drain of the sixth transistor M6 and the drain of the seventh transistor M7.

A gate of the seventh transistor M7 is coupled to the first-stage operational amplification circuit 21. For example, the gate of the seventh transistor M7 is coupled to the drain of the first transistor M1 and the drain of the fourth transistor M4. A source of the seventh transistor M7 is coupled to the ground end GND.

It may be understood that the first output sub-circuit 22a may generate the output signal $V_{OP}$ based on the drive signal $V_A$ from the first-stage operational amplification circuit 21 and the second drive signal from the third voltage end VBP under the enabling control of the second power voltage signal.

For example, refer to FIG. 3. The second output sub-circuit 22b includes an eighth transistor M8 and a ninth transistor M9. A gate of the eighth transistor M8 is coupled to the third voltage end VBP, a source of the eighth transistor M8 is coupled to the second power voltage end VDD2, and a drain of the eighth transistor M8 is coupled to a drain of the ninth transistor M9. The second output end VON is coupled to the drain of the eighth transistor M8 and the drain of the ninth transistor M9.

A gate of the ninth transistor M9 is coupled to the first-stage operational amplification circuit 21. For example, the gate of the ninth transistor M9 is coupled to the drain of the second transistor M2 and the drain of the fifth transistor M5. A source of the ninth transistor M9 is coupled to the ground end GND.

For example, both the sixth transistor M6 and the eighth transistor M8 are P-type transistors, and both the seventh transistor M7 and the ninth transistor M9 are N-type transistors.

It may be understood that the second output sub-circuit 22b may generate the output signal $V_{ON}$ based on the drive signal $V_B$ from the first-stage operational amplification circuit 21 and the second drive signal from the third voltage end VBP under the enabling control of the second power voltage signal.

In the foregoing embodiment of this application, the operational amplifier 2 includes the first transistor M1 to the ninth transistor M9, and a quantity of transistors is small. This helps reduce a power voltage (the first power voltage signal and the second power voltage signal) of the operational amplifier 2, thereby helping reduce power consumption of the operational amplifier 2.

In some embodiments, refer to FIG. 2 and FIG. 3. The operational amplifier 2 further includes a compensation circuit 25. The compensation circuit 25 is coupled between the first-stage operational amplification circuit 21 and the second-stage operational amplification circuit 22, and the compensation circuit 25 may be configured to improve stability of the operational amplifier 2.

For example, the compensation circuit 25 includes a first compensation sub-circuit 25a and a second compensation sub-circuit 25b. The first compensation sub-circuit 25a is coupled between the first-stage operational amplification circuit 21 and the first output sub-circuit 22a, the second compensation sub-circuit 25b is coupled between the first-stage operational amplification circuit 21 and the second output sub-circuit 22b.

For example, refer to FIG. 3. The first compensation sub-circuit 25a includes a first capacitor C1 and a first resistor R1 that are disposed in series, and the first capacitor C1 and the first resistor R1 that are disposed in series are coupled between the first-stage operational amplification circuit 21 and the first output sub-circuit 22a. The second compensation sub-circuit 25b includes a second capacitor C2 and a second resistor R2 that are disposed in series, and the second capacitor C2 and the second resistor R2 that are disposed in series are coupled between the first-stage operational amplification circuit 21 and the second output sub-circuit 22b.

In some embodiments, refer to FIG. 3. The operational amplifier 2 further includes a common-mode feedback circuit 26. The common-mode feedback circuit 26 is coupled to the signal output end (VOP and VON) and the first current source $I_1$. The common-mode feedback circuit 26 is configured to: generate and output an error feedback signal to the first current source $I_1$ based on the output signal ($V_{OP}$ and $V_{ON}$) from the signal output end, to feed back the error feedback signal to the first-stage operational amplification circuit 21.

It may be understood that the common-mode feedback circuit 26 is coupled to the first output end VOP and the second output end VON of the second-stage operational amplification circuit 22, and is coupled to the feedback voltage input end VFB of the first current source $I_1$.

For example, refer to FIG. 3. The common-mode feedback circuit 26 includes a common-mode detection (Common-Mode Detection, CMD) circuit 26a and a differential input single-ended output amplifier 26b. An input end of the common-mode detection circuit 26a is coupled to the signal output end, and an output end of the common-mode detection circuit 26a is coupled to a negative-phase input end of the differential input single-ended output amplifier 26b. The common-mode detection circuit 26a is configured to generate a common-mode voltage signal $V_{CM\_OUT}$ based on the output signal ($V_{OP}$ and $V_{ON}$).

Still refer to FIG. 3. A positive-phase input end of the differential input single-ended output amplifier 26b is configured to receive a reference voltage signal $V_{CM}$, an output end of the differential input single-ended output amplifier 26b is coupled to the feedback voltage input end VFB of the first current source $I_1$, and the differential input single-ended output amplifier 26b is configured to generate and output the error feedback signal based on the common-mode voltage signal $V_{CM\_OUT}$ and the reference voltage signal $V_{CM}$.

In addition, the differential input single-ended output amplifier 26b is further coupled to the first power voltage end VDD1, and the first power voltage end VDD1 is further configured to transmit the first power voltage signal to the differential input single-ended output amplifier 26b, to supply power to the differential input single-ended output amplifier 26b.

The operational amplifier 2 provided in some embodiments of this application may form a functional module together with a feedback circuit. The functional module may include, for example, a trans-impedance amplifier (Trans-Impedance Amplifier, TIA) and a filter.

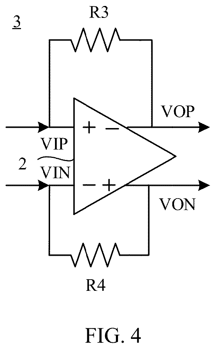

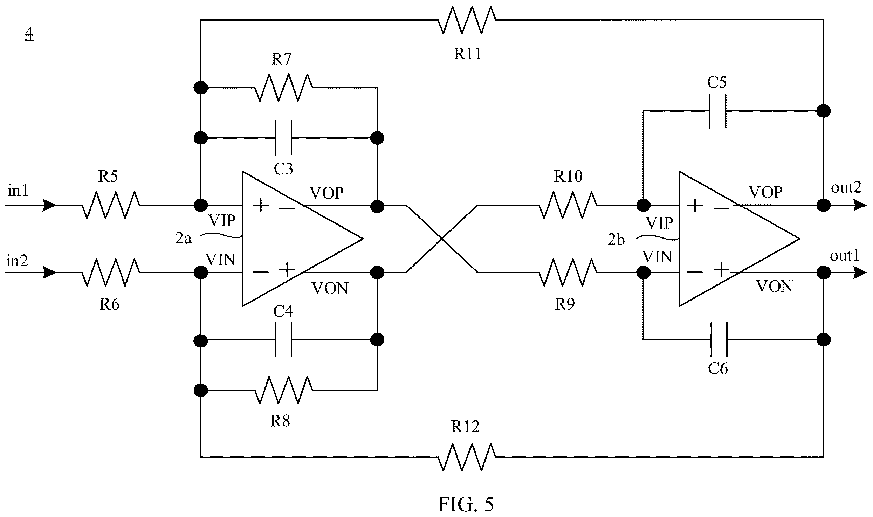

FIG. 4 is a circuit diagram of a trans-impedance amplifier according to an embodiment of this application. FIG. 5 is a circuit diagram of a filter according to an embodiment of this application.

Refer to FIG. 4. A trans-impedance amplifier 3 includes an operational amplifier 2, a third resistor R3, and a fourth resistor R4. A first input end VIP of the operational amplifier 2 is coupled to a first output end VOP via the third resistor R3, and a second input end VIN is coupled to a second output end VON via the fourth resistor R4.

According to the trans-impedance amplifier 3 provided in the foregoing embodiment of this application, the operational amplifier 2 having a class AB input stage circuit is used, so that the trans-impedance amplifier 3 has performance like low noise, low power consumption, high rate, and small area.

Refer to FIG. 5. A filter 4 includes a first operational amplifier 2a and a second operational amplifier 2b, a fifth resistor R5 to a twelfth resistor R12, and a third capacitor C3 to a sixth capacitor C6.

The filter 4 further includes a first signal input end in1 and a first signal output end out1 that correspond to each other, and a second signal input end in2 and a second signal output end out2 that correspond to each other.

A first input end VIP of the first operational amplifier 2a is coupled to the first signal input end in1 via the fifth resistor R5, and a second input end VIN is coupled to the second signal input end in2 via the sixth resistor R6. In addition, the seventh resistor R7 and the third capacitor C3 are disposed in parallel between the first input end VIP and a first output end VOP of the first operational amplifier 2a, and the eighth resistor R8 and the fourth capacitor C4 are disposed in parallel between the second input end VIN and a second output end VON.

A second input end VIN of the second operational amplifier 2b is coupled to the first output end VOP of the first operational amplifier 2a via the ninth resistor R9. A first input end VIP of the second operational amplifier 2b is coupled to the second output end VON of the first operational amplifier 2a via the tenth resistor R10. In addition, the fifth capacitor C5 is connected between the first input end VIP and a first output end VOP of the second operational amplifier 2b, and the sixth capacitor C6 is connected between the second input end VIN and a second output end VON. The first output end VOP of the second operational amplifier 2b is coupled to the second signal output end out2, and the second output end VON is coupled to the first signal output end out1.

In addition, the eleventh resistor R11 is connected between the first input end VIP of the first operational amplifier 2a and the first output end VOP of the second operational amplifier 2b. The twelfth resistor R12 is connected between the second input end VIN of the first operational amplifier 2a and the second output end VON of the second operational amplifier 2b.

According to the filter 4 provided in the foregoing embodiment of this application, the first operational amplifier 2a and the second operational amplifier 2b that have class AB input stage circuits are used, so that the filter 4 has performance like low noise, low power consumption, high rate, and small area. It is verified that noise performance of the filter 4 is improved by at least 3 dB.

According to the operational amplifier, the chip, and the electronic device provided in embodiments of this application, the operational amplifier includes the first-stage operational amplification circuit and the second-stage operational amplification circuit. The first-stage operational amplification circuit uses the class AB input stage circuit architecture. Because the class AB input stage circuit has the features such as low noise, low power consumption, high rate, and small area, the operational amplifier has the performance like low noise, low power consumption, high rate, and small area.

In addition, the first-stage operational amplification circuit is coupled to the first power voltage end, and the first power voltage end is configured to transmit the first power voltage signal to the first-stage operational amplification circuit, to supply power to the first-stage operational amplification circuit. The second-stage operational amplification circuit is coupled to the second power voltage end, and the second power voltage end is configured to provide the second power voltage signal for the second-stage operational amplification circuit, to supply power to the second-stage operational amplification circuit.

The voltage value of the first power voltage signal is set to be greater than the voltage value of the second power voltage signal, so that the power voltage of the first-stage operational amplification circuit is greater than the power voltage of the second-stage operational amplification circuit. A maximum output voltage of the second-stage operational amplification circuit may be close to the power voltage (the second power voltage signal) of the second-stage operational amplification circuit. When the second-stage operational amplification circuit is coupled to the first-stage operational amplification circuit via the feedback circuit, a maximum input voltage of the first-stage operational amplification circuit may be close to the second power voltage signal. Therefore, the power voltage (the first power voltage signal) of the first-stage operational amplification circuit is constantly greater than the input voltage of the first-stage operational amplification circuit, so that the first-stage operational amplification circuit can be prevented from being locked.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

**Claims**

1. An operational amplifier, comprising:

   a first power voltage end, configured to receive a first power voltage signal;
   a first-stage operational amplification circuit, comprising a signal input end, wherein the first-stage operational amplification circuit is coupled to the first power voltage end, and is configured to: receive an input signal via the signal input end, and amplify the input signal under enabling control of the first power voltage signal, to generate a first drive signal;
   a second power voltage end, configured to receive a second power voltage signal; and
   a second-stage operational amplification circuit, comprising a signal output end, wherein the second-stage operational amplification circuit is coupled to the first-stage operational amplification circuit and the second power voltage end, and is configured to: generate an output signal based on the first drive signal under enabling control of the second power voltage signal, and output the output signal via the signal output end, wherein
   a voltage value of the first power voltage signal is greater than a voltage value of the second power voltage signal.

2. The operational amplifier according to claim 1, wherein the first-stage operational amplification circuit comprises a first differential input pair and a first current source;

   the first differential input pair comprises a first transistor and a second transistor, and the first current source comprises a third transistor; and
   a gate of the first transistor and a gate of the second transistor are separately coupled to the signal input end, a source of the first transistor and a source of the second transistor are separately coupled to a drain of the third transistor, and a source of the third transistor is coupled to the first power voltage end.

3. The operational amplifier according to claim 2, wherein the first transistor, the second transistor, and the third transistor are all P-type transistors.

4. The operational amplifier according to claim 2 or 3, wherein the first-stage operational amplification circuit further comprises a second differential input pair and a second current source; and
   the second differential input pair comprises a fourth transistor and a fifth transistor, a gate of the fourth transistor and a gate of the fifth transistor are separately coupled to the signal input end, a source of the fourth transistor and a source of the fifth transistor are separately coupled to the second current source, a drain of the fourth transistor is coupled to a drain of the first transistor, and a drain of the fifth transistor is coupled to a drain of the second transistor.

5. The operational amplifier according to claim 4, wherein both the fourth transistor and the fifth transistor are N-type transistors.

6. The operational amplifier according to any one of claims 2 to 5, wherein the operational amplifier further comprises a common-mode feedback circuit, coupled to the signal output end of the second-stage operational amplification circuit and the first current source, and configured to: generate and output an error feedback signal to the first current source based on the output signal from the signal output end.

7. The operational amplifier according to claim 6, wherein the common-mode feedback circuit comprises a common-mode detection circuit and a differential input single-ended output amplifier;

an input end of the common-mode detection circuit is coupled to the signal output end, an output end of the common-mode detection circuit is coupled to a negative-phase input end of the differential input single-ended output amplifier, and the common-mode detection circuit is configured to generate a common-mode voltage signal based on the output signal; and
a positive-phase input end of the differential input single-ended output amplifier is configured to receive a reference voltage signal, an output end of the differential input single-ended output amplifier is coupled to the first current source, and the differential input single-ended output amplifier is configured to generate and output the error feedback signal based on the common-mode voltage signal and the reference voltage signal.

8. The operational amplifier according to any one of claims 2 to 7, wherein

the voltage value of the first power voltage signal is $V_{dd1}$;
the voltage value of the second power voltage signal is $V_{dd2}$ ;
a gate-source voltage difference of the first transistor during operating in a saturated region is $V_{GS1}$;
a gate-source voltage difference of the second transistor during operating in a saturated region is $V_{GS2}$ ; and
a source-drain voltage difference of the third transistor in a critical state between a linear region and a saturated region is $V_{DSat3,}$ wherein

$$\left|V_{dd1}\right| > \left|V_{dd2}\right| + \left|V_{GS1}\right| + \left|V_{DSat3}\right|, \text{ and } \left|V_{dd1}\right| > \left|V_{dd2}\right| + \left|V_{GS2}\right| + \left|V_{DSat3}\right|.$$

9. The operational amplifier according to any one of claims 1 to 8, wherein the operational amplifier further comprises a third voltage end, and the third voltage end is configured to receive a second drive signal; and
the second-stage operational amplification circuit is coupled to the first-stage operational amplification circuit, the second power voltage end, and the third voltage end, and is configured to generate the output signal based on the first drive signal and the second drive signal under the enabling control of the second power voltage signal.

10. The operational amplifier according to claim 9, wherein the second-stage operational amplification circuit comprises a first output sub-circuit and a second output sub-circuit;

the first output sub-circuit comprises a sixth transistor and a seventh transistor, a gate of the sixth transistor is coupled to the third voltage end, and a source of the sixth transistor is coupled to the second power voltage end;
a gate of the seventh transistor is coupled to the first-stage operational amplification circuit, and a drain of the seventh transistor is coupled to a drain of the sixth transistor;
the second output sub-circuit comprises an eighth transistor and a ninth transistor, a gate of the eighth transistor is coupled to the third voltage end, and a source of the eighth transistor is coupled to the second power voltage end; and
a gate of the ninth transistor is coupled to the first-stage operational amplification circuit, and a drain of the ninth transistor is coupled to a drain of the eighth transistor.

11. The operational amplifier according to claim 10, wherein both the sixth transistor and the eighth transistor are P-type transistors; and
both the seventh transistor and the ninth transistor are N-type transistors.

12. The operational amplifier according to claim 10 or 11, wherein the operational amplifier further comprises a compensation circuit, coupled between the first-stage operational amplification circuit and the second-stage operational amplification circuit.

13. The operational amplifier according to claim 12, wherein the compensation circuit comprises a first compensation sub-circuit and a second compensation sub-circuit;

the first compensation sub-circuit comprises a first capacitor and a first resistor that are disposed in series and are coupled between the first-stage operational amplification circuit and the first output sub-circuit; and

the second compensation sub-circuit comprises a second capacitor and a second resistor that are disposed in series and are coupled between the first-stage operational amplification circuit and the second output sub-circuit.

14. A chip, comprising:

a third resistor and a fourth resistor; and

the operational amplifier according to any one of claims 1 to 13, wherein

the signal input end comprises a first input end and a second input end, the signal output end comprises a first output end and a second output end, the first input end corresponds to the first output end, and the second input end corresponds to the second output end; and

the first input end is coupled to the first output end via the third resistor, and the second input end is coupled to the second output end via the fourth resistor.

15. An electronic device, comprising:

the chip according to claim 14; and

a circuit board, wherein the chip is coupled to the circuit board.

FIG. 1

FIG. 2

EP 4 679 711 A1

FIG. 3

FIG. 4

FIG. 5

## INTERNATIONAL SEARCH REPORT

| International application No. |
|---|
| **PCT/CN2023/139097** |

### A. CLASSIFICATION OF SUBJECT MATTER

H03F 1/02(2006.01)i

According to International Patent Classification (IPC) or to both national classification and IPC

### B. FIELDS SEARCHED

Minimum documentation searched (classification system followed by classification symbols)

IPC: H03F

Documentation searched other than minimum documentation to the extent that such documents are included in the fields searched

Electronic data base consulted during the international search (name of data base and, where practicable, search terms used)

VEN, CNABS, CNTXT, WOTXT, EPTXT, USTXT, CNKI, IEEE: 运算, 放大器, 放大模块, 放大单元, 电源, 电压, 使能, 驱动, 差分, 大于, 高于, 较高, 较大, 小于, 较小, 低于, 较低, 补偿, 共模, AB类: operations, amplifier, amplification Module, amplification unit, power supply, voltage, enable, drive, differential, greater, higher, larger, smaller, lower, compensation, common mode, class AB

### C. DOCUMENTS CONSIDERED TO BE RELEVANT

| Category* | Citation of document, with indication, where appropriate, of the relevant passages | Relevant to claim No. |
|---|---|---|
| A | CN 114584083 A (HUNAN UNIVERSITY) 03 June 2022 (2022-06-03) description, paragraphs [0018]-[0035], and figures 2-3 | 1-15 |
| A | CN 103338014 A (MEDIATEK INC.) 02 October 2013 (2013-10-02) entire document | 1-15 |
| A | CN 101911479 A (TEXAS INSTRUMENTS INC.) 08 December 2010 (2010-12-08) entire document | 1-15 |
| A | CN 101645252 A (NEC ELECTRONICS CORP.) 10 February 2010 (2010-02-10) entire document | 1-15 |
| A | CN 104660195 A (XIDIAN UNIVERSITY) 27 May 2015 (2015-05-27) entire document | 1-15 |
| A | US 2018234056 A1 (BOE TECHNOLOGY GROUP CO., LTD.) 16 August 2018 (2018-08-16) entire document | 1-15 |

☑ Further documents are listed in the continuation of Box C.    ☑ See patent family annex.

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **23 February 2024** | **19 March 2024** |

| Name and mailing address of the ISA/CN | Authorized officer |
|---|---|
| **China National Intellectual Property Administration (ISA/CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/139097** |

**C. DOCUMENTS CONSIDERED TO BE RELEVANT**

| Category* | Citation of document, with indication, where appropriate, of the relevant passages | Relevant to claim No. |
| --- | --- | --- |
| A | US 2021013851 A1 (BROOKHAVEN SCIENCE ASSOCIATES, LLC) 14 January 2021 (2021-01-14)<br>entire document | 1-15 |

Form PCT/ISA/210 (second sheet) (July 2022)

**INTERNATIONAL SEARCH REPORT**
Information on patent family members

International application No.

**PCT/CN2023/139097**

| Patent document cited in search report | | | Publication date (day/month/year) | Patent family member(s) | | | Publication date (day/month/year) |
|---|---|---|---|---|---|---|---|
| CN | 114584083 | A | 03 June 2022 | | None | | |
| CN | 103338014 | A | 02 October 2013 | US | 2015028951 | A1 | 29 January 2015 |
| | | | | US | 2013200953 | A1 | 08 August 2013 |
| CN | 101911479 | A | 08 December 2010 | WO | 2009059185 | A2 | 07 May 2009 |
| | | | | US | 2009108934 | A1 | 30 April 2009 |
| CN | 101645252 | A | 10 February 2010 | US | 2009303210 | A1 | 10 December 2009 |
| | | | | JP | 2009244830 | A | 22 October 2009 |
| CN | 104660195 | A | 27 May 2015 | | None | | |
| US | 2018234056 | A1 | 16 August 2018 | WO | 2017211134 | A1 | 14 December 2017 |
| | | | | CN | 106026937 | A | 12 October 2016 |
| US | 2021013851 | A1 | 14 January 2021 | | None | | |

Form PCT/ISA/210 (patent family annex) (July 2022)

**EP 4 679 711 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- CN 202310357521